# EUROPEAN PATENT SPECIFICATION

(11) **EP 0 220 410 B1**
(45) Date of publication and mention of the grant of the patent: **07.04.1993**
(21) Application number: 86111645.7
(22) Date of filing: 22.08.1986
(51) Int. Cl.: H01L 27/10, H01L 21/82

(54) **A dynamic random access memory device having a single-crystal transistor on a trench capacitor structure and a fabrication method therefor**
Dynamische Speichervorrichtung mit wahlfreiem Zugriff mit einem monokristallinen Transistor auf einer rillenartigen Kondensatorstruktur und Herstellungsverfahren dafür
Dispositif de mémoire dynamique à accès aléatoire comprenant un transistor monocristallin sur une structure de condensateur à sillon et son procédé de fabrication

(30) Priority: 21.10.1985 US 789675
(43) Date of publication of application: 06.05.1987
(73) Proprietor: International Business Machines Corporation, Armonk, N.Y. 10504 (US)
(72) Inventor: Lu, Nicky Chau-Chun, Yorktown Heights New York 10598 (US)
(74) Representative: Burt, Roger James, Dr.

(56) References cited:
- EP-A- 0 108 390
- EP-A- 0 167 764
- SOLID STATE TECHNOLOGY, vol. 27, no. 9, September 1984, pages 239-243, Port Washington, New York, US; L. JASTRZEBSKI: "Silicon CVD for SOI: principles and possible applications"

## Description

The present invention relates to a dynamic random access memory (DRAM) device, of the type including an access transistor and a storage capacitor formed on a single-crystal semiconductor chip, and to a fabrication method therefor.

The following references are typical of the state of the art of DRAM devices with trench capacitors.

US Patent 4,353,086 issued October 5, 1982 to Jaccodine et al entitled SILICON INTEGRATED CIRCUITS describes a dynamic random access memory in which individual cells, each including an access transistor and a storage capacitor, are formed in mesas formed on a silicon chip. The access transistor of each cell is formed on the top surface of the mesa. One plate of the storage capacitor of each cell is formed by the sidewall of the mesa and the other plate is formed by doped polycrystalline silicon which fills the grooves surrounding the mesas and is isolated therefrom by a silicon dioxide layer. By this geometry, large storage surfaces, and so large capacitances, can be obtained for each capacitor without using the surface area of the chip. In other embodiments, the mesas may include other forms of circuit elements.

EP-A-0 108 390, published May 16, 1984, shows a DRAM cell having a a trench capacitor and an access transistor.

US Patent 4,327,476 issued May 4, 1982 to Iwai et al entitled METHOD OF MANUFACTURING SEMICONDUCTOR DEVICES describes a method which comprises the steps of: forming at least one groove at a given location in a semiconductor substrate; laying an insulating film over the entire surface of the semiconductor substrate including the groove; depositing a layer of conductive material on the insulating film to a thickness greater than half the width of an opening of the groove; and forming a MOS capacitor electrode from the conductive layer left in the groove by etching the deposited conductive layer until the insulating film, other than its portion within the groove, is exposed.

US Patent 4,462,847 issued July 31, 1984 to Thompson et al entitled FABRICATION OF DIELECTRICALLY ISOLATED MICROELECTRONIC SEMICONDUCTOR CIRCUITS UTILIZING SELECTIVE GROWTH BY LOW PRESSURE VAPOUR DEPOSITION describes a method for the fabrication of microelectronic semiconductor circuits, including the step of concurrent low pressure deposition of mono-crystalline and poly-crystalline semiconductor material in a predetermined pattern. A dielectric isolated circuit is fabricated, by such selective epitaxial growth and a subsequent oxidation of both the mono- and poly-crystalline deposits. By controlling the ratio of the deposition rates, and by controlling the oxidation step, the poly-crystalline deposit is substantially fully converted to oxide, while the mono-crystalline deposit is only partly oxidised, leaving a substantially coplanar, isolated matrix of passivated mono-crystalline areas in which to fabricate circuit components for interconnection.

Growth of mono-crystalline silicon epitaxial layers is also known from Solid State Technology, vol. 27, no. 9, September 1984, pages 239-243, Port Washington, NY.

In Japanese Patent 58-137245, a technique is described to increase the area of an electrode without increasing the area of a plane by using the sidewall section of a groove dug into an Si substrate as the electrode surface of a capacitor. A field SiO₂ film is formed selectively onto a Si substrate through a LOCOS method, an etched groove is formed into the substrate and a capacitor insulating film made of Si₃N₄ is shaped onto these surfaces through a CVD method. The whole surface of the insulating film is coated with a plate represented by polycrystalline Si. A groove is buried with the same polycrystalline Si at that time. The plate is oxidised and a first inter-layer oxide film is formed, the Si₃N₄ film and an SiO₂ film are removed while using the oxide film as a mask, and a gate oxide film is formed through oxidation. A predetermined section is coated with a word line, and source-drain layers are formed in a section not coated with the plate and the gate through ion implantation, and a second inter-layer insulating film and the electrode are coated selectively.

The object of the present invention is to provide an improved DRAM device structure and a fabrication process therefor.

The present invention, according to a first aspect thereof, relates to a dynamic random access memory device of the type having a single-crystal transistor structure on a trench storage capacitor structure. The device comprises a single-crystal silicon substrate, a trench storage capacitor disposed in substrate, said capacitor including a region of doped polysilicon material isolated by a layer of insulation material and a single-crystal epitaxial silicon layer disposed on said substrate. An access transistor device is disposed over said trench capacitor, and has a source/drain region formed from the single-crystal epitaxial silicon layer material. A polysilicon region is disposed in a window in the single-crystal epitaxial silicon layer and said layer of insulation material over the trench capacitor connecting the source of the access transistor to the doped polysilicon material of the trench capacitor.

According to a second aspect of the invention, there is provided a method for fabricating a dynamic random access memory device having a single-crystal transistor device on a trench storage capacitor structure, comprising the steps of:
Step 1. forming a mask layer on a single-crystal silicon substrate; opening a window in said mask layer and etching a trench in said substrate beneath said window;
Step 2. forming a layer of insulation material on the surfaces of the trench to provide an insulation layer for said trench storage capacitor;
Step 3. filling said trench with polysilicon material and doping said polysilicon material;
Step 4. forming a layer of oxide over said polysilicon filled trench;
Step 5. removing said mask layer from said substrate;
Step 6. growing a doped epitaxial single-crystal silicon layer over said substrate and oxide covered trench regions;
Step 7. forming a mask layer over said epitaxial silicon layer;
Step 8. opening a window in said mask layer over said trench region and etching away said epitaxial silicon and oxide over said trench;
Step 9. refilling said window formed in step 8 with polysilicon material;
Step 10. removing said mask layer formed in step 7;
Step 11. forming a access transistor device over said trench by conventional gate oxide growth and definition, and source/drain dopant implantation.

In order that the invention may be more readily understood embodiments thereof will now be described with reference to the accompanying drawings, in which:-
Figure 1 is a schematic illustration of a side view in cross section of one form of three-dimensional DRAM device fabricated from bulk material.
Figure 2 is a schematic drawing of a detail of the top view of the DRAM device in Figure 1 illustrating the trench capacitor.
Figure 3 is a schematic illustration of a side view in cross section of another form of a three-dimensional DRAM device fabricated from film material.
Figure 4 is a schematic illustration of a side view in cross section of a further form of a three-dimensional DRAM device including a p-channel access transistor located inside an n-well in CMOS technology.
Figures 5, 6 and 7 illustrate the structure of Figure 1 or 2 at various stages in the fabrication process wherein the access transistor is made in the single-crystal bulk region.
Figure 8 illustrates a detail of the top view of the access transistor and trench capacitor structure of the device of Figure 4.
Figures 9 and 10 illustrate various stages in the fabrication process for the structure of Figure 3 wherein the access transistor is made in single-crystal film.

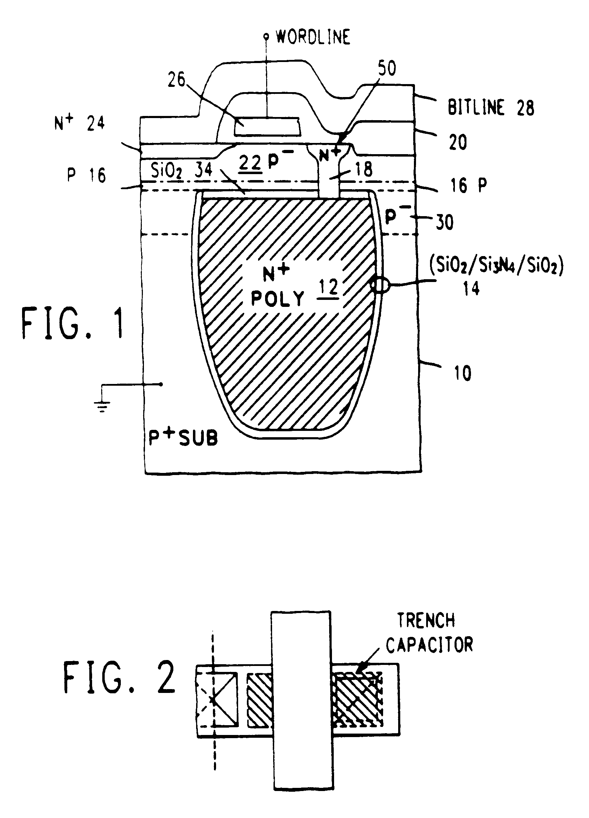

Figure 1 is a side view in cross section of a DRAM cell device including a silicon substrate 10 which, for the purposes of explanation, is P+ type. A trench is formed in substrate 10 and contains heavily doped N+ polysilicon 12. A composite film 14 of SiO₂/Si₃N₄/SiO₂ is located between the side wall of the trench 12 and the N+ polysilicon and forms an insulator for a storage capacitor formed by the trench. A thin layer 34 of SiO₂ is located over the polysilicon 12. A lightly doped p-type epi silicon layer 30 is located over the substrate 10 and the layer 34.

An access transistor for the DRAM cell is located on top of the trench storage capacitor. A layer of N+ doped material 18 connects the source region 50 of the transistor to the polysilicon 12 inside the trench. A medium doped P- region 16 on top of the trench surface is provided in case there is any significant amount of leakage current along the trench surface. However, this layer is not a necessary element of the structure.

The remaining elements of the transistor includes a gate 26 connected to a wordline. A bitline 28 is also shown, as is a recessed isolation region 20.

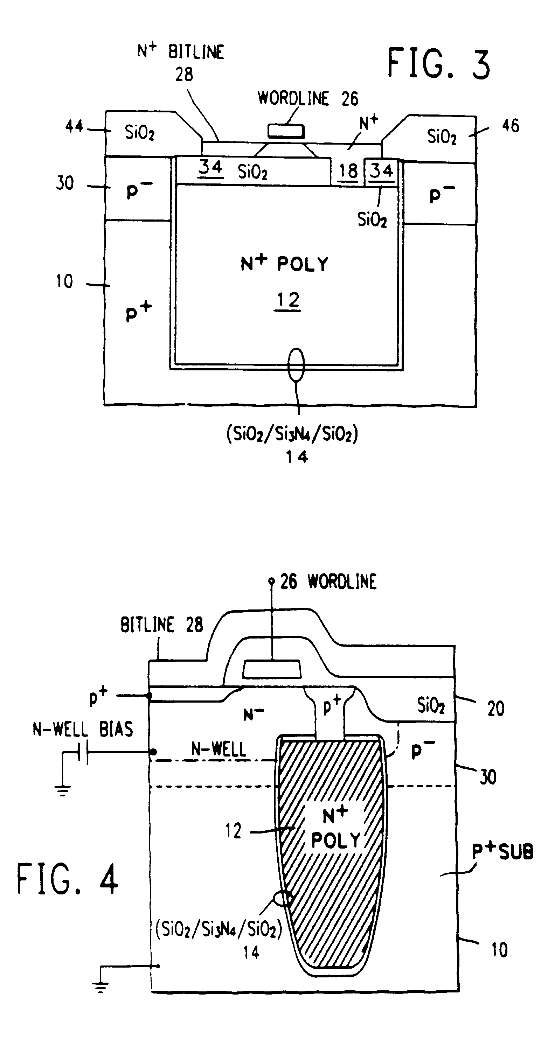

Depending on whether the transistor is made in either bulk or film material, two cell structures are shown in Figures 1 and 3 respectively.

Stacking the transistor on top of the trench capacitor allows the dynamic RAM device illustrated to be made in just one transistor area. Without stacking, direct scaling down of the trench capacitor cell has to result in squeezing of the trench capacitor opening. This results in a large trench depth-to-width aspect ratio for sufficient charge storage and makes the trench etching and refilling process very difficult. With the stacking arrangement, because the trench opening can be as large as the transistor active region, a smaller trench depth-to-width aspect ratio can be obtained. The stacking arrangement also provides several advantages such as smaller bitline capacitance due to smaller dimension along the bitline direction, high noise immunity due to the signal-charge stored inside the trench capacitor, and smooth surface topography. An advantage of the arrangement illustrated is that it provides a technique that allows stacking a memory device which has a single crystal film or bulk transistor on top of the trench capacitor without the usual problems such as recrystallising polysilicon film into single-crystal material.

As previously stated, the memory cell structure is shown in Figure 1. The access transistor is stacked on top of the trench capacitor. The N+ doped material 18 connects the source region 50 of the access transistor to the polysilicon 12 inside the trench. A medium doped P-region 16 right on top of the trench surface is added in case there is any significant amount of leakage current along the trench surface (not mandatory). A similar structure, shown in Figure 4, can be built for a P- channel access transistor located inside an N- well in a CMOS technology with a change of the dopant polarity of the transistor source/drain and polysilicon inside the trench from N- type to P- type. One extra process step to form the N- well is required.

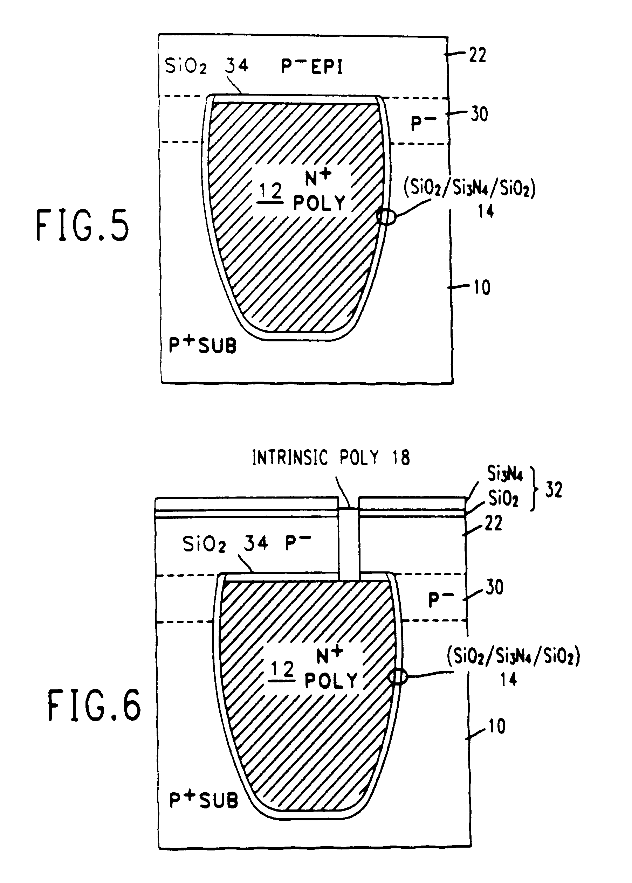

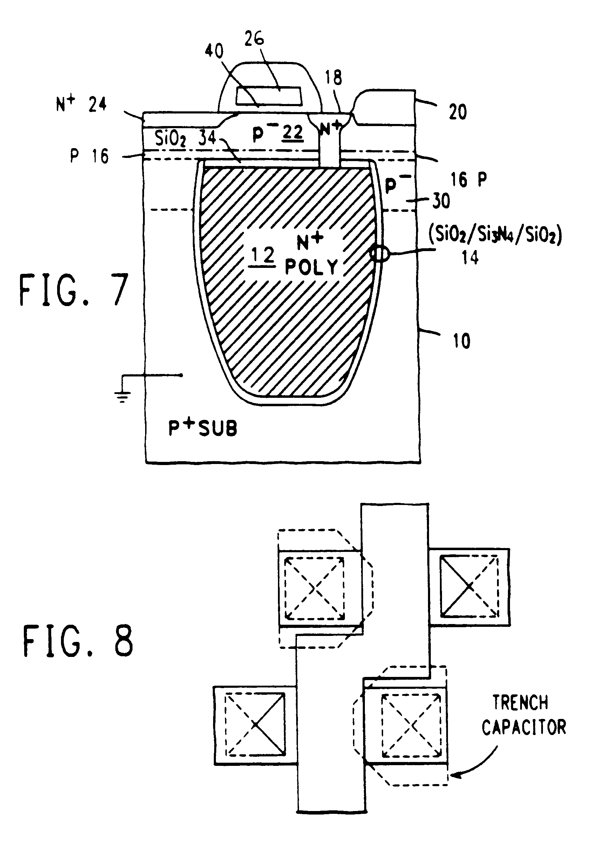

The method steps for fabricating the memory cell structure illustrated in Figure 1 are described as follows.
Step 1. Assuming the silicon substrate 10 has a P- epitaxial layer 30 on top of a heavily P+ doped wafer (it can be just a P+ wafer), a composite layer 14 of SiO₂ and Si₃N₄ is formed over the P- epi layer. After suitable lithography steps, part of this Si₃N₄/SiO₂ layer is removed to leave a window such that a trench can be formed in the silicon substrate 10 by RIE (reactive-ion etching).
Step 2. After a thin oxide layer is thermally grown, a thin nitride layer is deposited and thermally densified in an oxide ambient to form a composite film of SiO₂/Si₃N₄/SiO₂ for the capacitor storage insulator layer 14. Then a thick polysilicon film 12 is deposited to fill the trench and is heavily N+ doped as shown in Figure 5.
Step 3. The polysilicon film 12 is planarised by RIE or by a mechanical and chemical polishing technique so that the surface of the polysilicon film 12 is lined up with the substrate surface. The nitride layer over the substrate surface is used for etch stop.
Step 4. Then a thin silicon oxide layer 34 is thermally grown "locally" over the polysilicon surface. No oxide is grown on the other regions because the other substrate surface is covered by the nitride layer.
Step 5. The nitride layer over the substrate is removed by isotropic etching. Then the oxide layer is removed on all the substrate surface except for the oxide layer 34 on the polysilicon film 12. The oxide grown on the polysilicon film in step 4 should be much thicker than the oxide underneath the nitride layer grown in step 2.
Step 6. Then a lightly doped P-type silicon layer 22 is epitaxially grown (Figure 5). Since all the single-crystal silicon substrate except small trench regions has been exposed to the epitaxial growth, abundant single-crystal seeds are available for both vertical and lateral epitaxy. For the trench regions, as the epi film thickness is made larger than half the size of the trench opening, a single-crystal epitaxial layer can be obtained.
Step 7. A composite layer 32 of SiO₂ and Si₃N₄ is then formed over the P- epi layer, as shown in Figure 6. After suitable lithography steps part of this Si₃N₄/SiO₂ layer 32 is removed to leave a window such that RIE can be used to remove the silicon and oxide on top of the capacitor formed by the trench.
Step 8. Then an intrinsic polysilicon film 18 is used to refill the window and is planarised by RIE or by a mechanical and chemical polishing technique so that the surface of the intrinsic polysilicon is lined up with the silicon surface of layer 32, as shown in Figure 6. The nitride part of layer 32 over the silicon surface is used for etch stop. The nitride and oxide masking layer 32 is then removed.
Step 9. Then the conventional ROX or shallow trench isolation 20 (Figure 7) can be used. If the transistor will be made inside the N-well, an N- well implant is needed for the cell region.
Step 10. After isolation, gate oxide 40 growth, gate 26 definition, and formation of oxide/nitride spacer, the source/drain 24 is formed by a shallow implant of N+ dopants. This implant has to cover the intrinsic polysilicon film 18. Because the intrinsic polysilicon has high diffusivity for the source/drain dopants, after thermal process, the intrinsic polysilicon can be heavily doped, providing the connection for the source region of the access device to the polysilicon 12 inside the trench as shown in Figure 7. Afterwards, the conventional MOS process is continued to complete the cell structure. The entire process is also fully compatible to CMOS technology.

The above process results in the memory cell structure shown in Figure 1, or in Figure 4 where the access transistor is made in the single-crystal bulk region. The body of the access transistor is directly biased through the epi region 22 by a substrate voltage supply or biased by an N- well voltage supply. From a practical viewpoint, if there is any defect region due to lateral epitaxial growth, this region can be hidden in the source diffusion region and most of the defects are removed in such steps as forming the intrinsic polysilicon plug 18 to the trench capacitor and isolation region (e.g. shallow trench isolation). A high-quality epitaxial layer can always be reserved for the channel region of the access transistor (Figure 8).

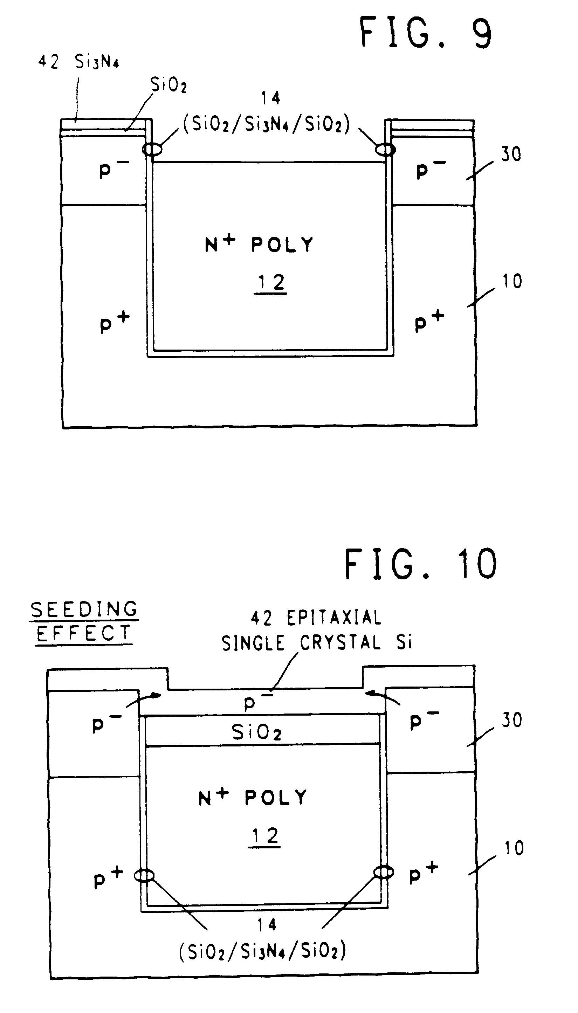

Similar principles can be used to realise the cell structure shown in Figure 3, where the transistor is made in a single-crystal film and located even within the trench-capacitor planar boundary by using complete oxide isolation. The fabrication procedures are as follows.
Steps A and B are the same as the previously described steps 1 and 2.
Step C. The polysilicon film 18 is planarised by RIE or by a mechanical and chemical polishing technique so that the surface of the polysilicon film 12 is "below" the substrate surface as shown in Figure 9. The nitride layer 42 over the substrate surface is used for etch stop.
Steps D and E are the same as steps 4 and 5 previously described.
Step F. Then a lightly doped P- type silicon layer is epitaxially grown as shown in Figure 10. Since all the single-crystal silicon substrate and the silicon sidewalls above the oxide layer in the trench, except small trench-oxide regions, have been exposed to the epitaxial growth, abundant single-crystal seed is available for both vertical and lateral epitaxy. For the trench regions, as the epi film thickness is made larger than half the size of the trench opening, the single-crystal epitaxial layer 42 can be obtained.
Steps G and H are the same as steps 7 and 8 previously described.
Step I. Then the conventional ROX or shallow trench isolation can be used. Referring to Figure 3, a complete oxide isolation 44 and 46 can be used to fully isolate the access transistor film which is located within the trench capacitor planar boundary. Although the body of the transistor can be not directly biased, by making the transistor film thin enough, no significant Kink effect can affect the cell operation.
Step J is the same as step 10 previously described. Figure 3 shows the final cell structure where the access transistor is fully isolated by oxide, resulting in small parasitic capacitance.

What has been described is a new one-transistor dynamic memory cell structure which has a "single-crystal" transistor in either bulk or film material stacked on top of a trench capacitor. The single-crystal is obtained directly from epitaxy instead of invoking any recrystallisation process.

What has also been described is a new processing method to allow growing single-crystal material on top of the trench capacitor which is not composed of single-crystal material. The key point of this new method is to expose the silicon region surrounding the trench capacitor to provide sufficient seeding area for epitaxial growth over the trench capacitor. This enables different kinds of devices including horizontal and vertical transistors, diodes, resistors, etc., to be made in single crystal and stacked directly on top of the trench capacitor.

## Claims

1. A dynamic random access memory device having a single-crystal transistor structure on a trench storage capacitor structure comprising: a single-crystal silicon substrate (10), a trench storage capacitor disposed in said substrate, said capacitor including a region of doped polysilicon material (12) isolated by a layer (14) of insulation material, a single-crystal epitaxial silicon layer (30) disposed on said substrate, an access transistor device disposed over said trench capacitor, said access transistor device having a source/drain region formed from said single-crystal epitaxial silicon layer material, and a polysilicon region disposed in a window in said single-crystal epitaxial silicon layer and said layer of insulation material over said trench capacitor connecting said source of said access transistor to said doped polysilicon material of said trench capacitor.

2. A dynamic memory device according to claim 1 wherein said substrate includes a heavily doped P+ doped silicon wafer and a P-epitaxial silicon layer disposed on said P+ doped silicon wafer.

3. A method for fabricating a dynamic random access memory device having a single-crystal transistor device on a trench storage capacitor structure, comprising the steps of:
Step 1. forming a mask layer on a single-crystal silicon substrate (10), opening a window in said mask layer and etching a trench in said substrate beneath said window;
Step 2. forming a layer (14) of insulation material on the surfaces of the trench to provide an insulation layer for said trench storage capacitor;
Step 3. filling said trench with polysilicon material and doping said polysilicon material;
Step 4. forming a layer (34) of oxide over said polysilicon filled trench;
Step 5. removing said mask layer from said substrate;
Step 6. growing a doped epitaxial single-crystal silicon layer (22) over said substrate and oxide covered trench regions;
Step 7. forming a mask layer over said epitaxial silicon layer;
Step 8. opening a window in said mask layer over said trench region and etching away said epitaxial silicon and oxide over said trench;
Step 9. refilling said window formed in step 8 with polysilicon material (18);
Step 10. removing said mask layer formed in step 7;
Step 11. forming an access transistor device over said trench by conventional gate oxide growth and definition, and source/drain dopant implantation.

4. A method according to claim 3 wherein said epitaxial layer grown in step 6 is grown from single-crystal seeds from said single-crystal silicon substrate to provide a single-crystal epitaxial layer, and wherein said access transistor device formed in step 11 is composed on said single-crystal material.

5. A method according to claim 4 wherein said single-crystal silicon substrate is a heavily P+ doped wafer.

6. A method according to claim 4 wherein said single-crystal silicon substrate further includes a P- epitaxial layer disposed on top of said heavily P+ doped wafer.

7. A method according to claim 4 wherein said mask layer formed in step 1 is a composite layer of silicon oxide and silicon nitride.

8. A method according to claim 4 wherein a composite layer of silicon oxide and silicon nitride on silicon oxide is formed on the surfaces of the trench etched in Step 1 prior to filling said trench with polysilicon material in step 3, said composite layer provided an insulation layer for said trench storage capacitor.

9. A method according to claim 4 wherein said step 11 further includes heavily doping said polysilicon material refilled in step 9 for providing a connection from the source of said access transistor to said polysilicon material in said trench.

## Patentansprüche

1. Eine dynamische Speichervorrichtung mit wahlfreiem Zugriff (DRAM), die eine monokristallische Transistorstruktur aufweist und sich auf einer Rillenspeicherkondensatorstruktur befindet, die folgendes aufweist: ein monokristallisches Silikonsubstrat 10, einen Rillenspeicherkondensator, der sich in diesem Substrat befindet - dieser Kondensator enthält einen Bereich gedopten Polysilikonmaterials 12, das durch eine Schicht 14 aus Isolationsmaterial isoliert ist, des weiteren eine monokristallische epitaxische Silikonschicht 30, die sich auf diesem Substrat befindet, eine Zugriffstransistoreinrichtung, die sich auf dem genannten Rillenkondensator befindet - bei dieser Zugriffstransistoreinrichtung wird ein Source/Drain-Bereich aus dem Material der genannten monokristallischen epitaxischen Silikonschicht gebildet, und einen Polysilikonbereich, der sich in einem Fenster in der genannten monokristallischen epitaxischen Silikonschicht befindet und die Schicht aus Isolationsmaterial, die sich über dem Rillenkondensator befindet und die Quelle des Zugriffstransistors mit dem gedopten Polysilikonmaterial des genannten Rillenkondensators verbindet.

2. Eine dynamische Speichereinrichtung in Übereinstimmung mit Anspruch 1, wobei das Substrat eine kräftig gedopte p+ Silikonscheibe und eine p- epitaxische Silikonschicht, die sich auf der genannten p+ gedopten Silikonscheibe befindet, enthält.

3. Ein Verfahren zur Herstellung einer dynamischen Speichervorrichtung mit wahlfreiem Zugriff (DRAM) mit einer monokristallischen Transistoreinrichtung auf einer Rillenspeicherkondensatorstruktur; dieses Verfahren setzt sich aus folgenden Schritten zusammen:
Schritt 1. Bildung einer Maskenschicht auf einem monokristallischen Silikonsubstrat 10; Öffnung eines Fensters in der genannten Maskenschicht und Ätzung einer Rille in das genannte Substrat unter dem genannten Fenster;
Schritt 2. Bildung einer Schicht 14 aus Isolationsmaterial auf den Flächen der Rille, um so eine Isolationsschicht für den genannten Rillenspeicherkondensator herzustellen;
Schritt 3. Füllung der genannten Rille mit Polysilikonmaterial und Dopen des genannten Polysilikonmaterials;
Schritt 4. Bildung einer Oxidschicht 34 oberhalb der genannten Rille, die mit Polysilikonmaterial gefüllt ist;
Schritt 5. Entfernung der genannten Maskenschicht vom genannten Substrat;
Schritt 6. Auftragen einer gedopten epitaxischen monokristallischen Silikonschicht 22 auf dem genannten Substrat und auf den oxidbedeckten Rillenbereichen;
Schritt 7. Bildung einer Maskenschicht über der genannten epitaxischen Silikonschicht;
Schritt 8. Öffnung eines Fensters in der genannten Maskenschicht oberhalb des genannten Rillenbereichs und Wegätzen des genannten epitaktischen Silikons und Oxids oberhalb der genannten Rille;
Schritt 9. Erneutes Füllen des in Schritt 8 gebildeten Fensters mit Polysilikonmaterial 18;
Schritt 10. Entfernung der in Schritt 7 gebildeten Maskenschicht;
Schritt 11. Bildung einer Zugriffstransistoreinrichtung oberhalb der genannten Rille durch konventionelles Tor-Oxidwachstum und Definition sowie durch Source-Drain-Doping-Implantation.

4. Ein Verfahren in Übereinstimmung mit Anspruch 3, wobei die in Schritt 6 gebildete epitaxische Schicht aus monokristallischen Keimen des monokristallischen Silikonsubstrats gebildet wird, um eine monokristallische epitaxische Schicht zu erhalten, und wobei die in Schritt 11 gebildete Zugriffstransistoreinrichtung auf dem monokristallischen Material angeordnet ist.

5. Ein Verfahren in Übereinstimmung mit Anspruch 4, wobei das monokristallische Silikonsubstrat eine kräftig p+ gedopte Scheibe ist.

6. Ein Verfahren in Übereinstimmung mit Anspruch 4, wobei das monokristallische Silikonsubstrat außerdem eine p- epitaxische Schicht enthält, die sich auf dieser kräftig p+ gedopten Scheibe befindet.

7. Ein Verfahren in Übereinstimmung mit Anspruch 4, wobei die in Schritt 1 gebildete Maskenschicht eine aus Silikonoxid und Silikonnitrid zusammengesetzte Schicht ist.

8. Ein Verfahren in Übereinstimmung mit Anspruch 4, wobei eine aus Silikonoxid und Silikonnitrid auf Silikonoxid gebildete Schicht auf den Flächen der Rillen gebildet wird, die in Schritt 1 geätzt wurde, bevor diese Rille in Schritt 3 mit Polysilikonmaterial gefüllt wurde; diese zusammengesetzte Schicht bildet eine Isolationsschicht für den genannten Rillenspeicherkondensator.

9. Ein Verfahren in Übereinstimmung mit Anspruch 4, wobei der genannte Schritt 11 des weiteren beinhaltet, daß das in Schritt 9 wieder aufgefüllte Polysilikonmaterial kräftig gedopt wird, um eine Verbindung von der Quelle des genannten Zugriffstransistors zum Polysilikonmaterial in der Rille herzustellen.

## Revendications

1. Dispositif de mémoire dynamique à accès direct ayant une structure de transistor monocristallin sur une structure de condensateur de stockage en sillon, comprenant : un substrat de silicium monocristallin (10), un condensateur de stockage en sillon disposé dans ledit substrat, ledit condensateur comportant une région de polysilicium dopé (12) isolée par une couche (14) de matière isolante, une couche de silicium épitaxial monocristallin (30) disposée sur ledit substrat, un dispositif transistor d'accès disposé sur ledit condensateur en sillon, ledit dispositif transistor d'accès ayant une région de source/drain formée à partir de ladite couche de silicium épitaxial monocristallin, et une région de polysilicium disposée dans une fenêtre de ladite couche de silicium épitaxial monocristallin et de ladite couche de matière isolante au-dessus dudit condensateur en sillon, reliant ladite source dudit transistor d'accès au dit polysilicium dopé dudit condensateur en sillon.

2. Dispositif de mémoire dynamique suivant la revendication 1, dans lequel ledit substrat comprend une tranche de silicium dopé de type P+ fortement dopé et une couche de silicium épitaxial de type P- disposée sur ladite tranche de silicium dopé de type P+.

3. Procédé de fabrication d'un dispositif de mémoire dynamique à accès direct ayant un dispositif transistor monocristallin sur une structure de condensateur de stockage en sillon, comprenant les étapes de :
Etape 1. formation d'une couche de masque sur un substrat en silicium monocristallin (10), ouverture d'une fenêtre dans ladite couche de masque et attaque d'un sillon ou d'une tranchée dans ledit substrat, sous ladite fenêtre ;
Etape 2. formation d'une couche 14 de matière isolante sur les surfaces du sillon pour constituer une couche d'isolation pour ledit condensateur de stockage en sillon ;
Etape 3. remplissage dudit sillon avec une matière de type polysilicium et dopage de ce polysilicium;
Etape 4. formation d'une couche (34) d'oxyde sur ledit sillon rempli de polysilicium ;
Etape 5. enlèvement de ladite couche de masque dudit substrat ;
Etape 6. génération d'une couche de silicium monocristallin épitaxial dopé (22) sur ledit substrat et les régions du sillon recouvertes d'oxyde ;
Etape 7. formation d'une couche de masque sur ladite couche de silicium épitaxial ;
Etape 8. ouverture d'une fenêtre dans ladite couche de masque, au-dessus de ladite région de sillon, et attaque et élimination dudit silicium épitaxial et dudit oxyde au-dessus dudit sillon ;
Etape 9. nouveau remplissage de ladite fenêtre formée à l'étape 8, avec une matière de type polysilicium (18) ;
Etape 10. enlèvement de ladite couche de masque formée à l'étape 7. ;
Etape 11. formation d'un dispositif transistor d'accès au-dessus dudit sillon, par génération et définition d'oxyde de grille usuel, et implantation d'un dopant de source/drain.

4. Procédé suivant la revendication 3, dans lequel ladite couche épitaxiale formée à l'étape 6 est engendrée à partir de germes monocristallins venant du dit substrat de silicium monocristallin pour produire une couche épitaxiale monocristalline, et dans lequel ledit dispositif transistor d'accès formé à l'étape 11 est composé sur ladite matière monocristalline.

5. Procédé suivant la revendication 4, dans lequel ledit substrat de silicium monocristallin est une tranche fortement dopée de type P+.

6. Procédé suivant la revendication 4, dans lequel ledit substrat de silicium monocristallin comprend en outre une couche épitaxiale de type P- disposée sur le dessus de ladite tranche fortement dopée P+.

7. Procédé suivant la revendication 4, dans lequel ladite couche de masque formée à l'étape 1 est une couche composite d'oxyde de silicium et de nitrure de silicium.

8. Procédé suivant la revendication 4, dans lequel une couche composite d'oxyde de silicium et de nitrure de silicium sur l'oxyde de silicium est formée sur les surfaces du sillon attaqué à l'étape 1, avant le remplissage dudit sillon avec la matière de type polysilicium à l'étape 3 , ladite couche composite constituant une couche isolante pour ledit condensateur de stockage en sillon.

9. Procédé suivant la revendication 4, dans lequel ladite étape 11 comprend en outre le dopage poussé de ladite matière de type polysilicium appliquée pour le nouveau remplissage à l'étape 9, afin de fournir une connexion entre la source dudit transistor d'accès et ladite matière de type polysilicium dans ledit sillon.
